Europäisches Patentamt

European Patent Office

Office européen des brevets

(19)

(11) Veröffentlichungsnummer : **0 388 410 B1**

(12) **EUROPÄISCHE PATENTSCHRIFT**

(45) Veröffentlichungstag der Patentschrift :
**12.08.92 Patentblatt 92/33**

(51) Int. Cl.⁵ : **H01S 3/085**

(21) Anmeldenummer : **88908935.5**

(22) Anmeldetag : **25.10.88**

(86) Internationale Anmeldenummer :
**PCT/DE88/00655**

(87) Internationale Veröffentlichungsnummer :
**WO 89/04558 18.05.89 Gazette 89/11**

(54) **LASERANORDNUNG MIT MINDESTENS EINEM LASERRESONATOR UND EINEM DAMIT VERKOPPELTEN PASSIVEN RESONATOR.**

(30) Priorität : **09.11.87 DE 3738053**

(43) Veröffentlichungstag der Anmeldung :
**26.09.90 Patentblatt 90/39**

(45) Bekanntmachung des Hinweises auf die
Patenterteilung :
**12.08.92 Patentblatt 92/33**

(84) Benannte Vertragsstaaten :
**DE FR GB**

(56) Entgegenhaltungen :
**EP-A- 0 158 565**
**EP-A- 0 213 965**
**US-A- 3 747 020**

(56) Entgegenhaltungen :
**IEEE JOURNAL OF QUANTUM ELECTRONICS, vol. QE-22, no. 7, Juli 1986, New York (US), A. ANTREASYAN et al.: "Monolithicintegration on InGaAsP/InP semiconductor lasers using the stop-cleaving technique", Seiten 1064-1076, siehe Abschnitt III Devicecharacteristics; Figur 9**

(73) Patentinhaber : **SIEMENS AKTIENGESELLSCHAFT Wittelsbacherplatz 2 W-8000 München 2 (DE)**

(72) Erfinder : **KAPPELER, Franz Narzissenstrasse 4 W-8039 Puchheim (DE)** Erfinder : **WOLF, Thomas Franz-Fendt-Weg 18 W-8000 München 83 (DE)**

## Beschreibung

Die Erfindung betrifft eine Laseranordnung mit mindestens einem Laserresonator und einem damit verkoppelten passiven Resonator.

Halbleiterlaseranordnungen, die in nur einer Mode schwingen, sind aus der Literatur bekannt (siehe z. B. R. Plastow et al, 9th IEEE ISLC, Rio de Janeiro, Aug. 1984 S. 72 ff., Z. L. Liau et al, Appl. Phys. Lett. 46 (1985) S. 115 ff., M. Ohshima et al, 9th IEEE ISLC, Rio de Janeiro, Aug. 1984 S. 188 ff., H. K. Choi et al, Elec. Lett. 19 (1983) S. 302 ff. , L. A. Coldren et al, Appl. Phys. Lett. 46 (1985) S. 5 ff.). Diese Anordnungen enthalten mehrere laseraktive und laserpassive Fabry-Perot-Resonatoren, die longitudinal verkoppelt sind. Die verschiedenen Anordnungen unterscheiden sich in ihren Koppelelementen. Bei den "Cleaved coupled cavity"-Lasern und den "Groove-coupled cavity"-Lasern wird ein Luftspalt mit planparallelen Spiegelflächen als Koppelelement zwischen zwei aktiven Laserresonatoren unterschiedlicher optischer Länge verwendet (siehe z. B. L. A. Coldren et al, Appl. Phys. Lett. Bd. 46 (1985) S. 5 ff.). Bei dem "Active-passive interference"-Laser wird ein passiver Resonator über eine Stufe in einer Wellenleiterstruktur an einen aktiven Laserresonator longitudinal angekoppelt (siehe z.- B. H. K. Choi und S. Wang, Elec. Lett. Bd. 19 (1983) S. 302 ff.). Bei dem "Internal reflection interference"-Laser erfolgt die Kopplung über eine in den Wellenleiter eingebaute Störung des Brechungsindexes (M. Ohshima et al, 9th IEEE ISLC, Rio de Janeiro, Aug. 1984 S. 188 ff.).

Diese Koppelelemente führen zu einer starken und frequenzabhängigen Kopplung. Zu starke Verkopplungen führen zu einer Destabilisierung des Arbeitspunktes des Lasers. Starke Frequenzabhängigkeit der Kopplung führt dazu, daß bei geringen Temperatur- bzw. Stromschwankungen abrupte Sprünge der Schwingfrequenz auftreten.

Der Erfindung liegt die Aufgabe zugrunde, eine weitere einmodige Laseranordnung anzugeben.

Die Aufgabe wird erfindungsgemäß gelöst, wie dies im Anspruch 1 angegeben ist. Da Mehrfachreflexionen zwischen dem Laserresonator und dem passiven Resonator vom Aufbau her verhindert sind, ist der Koppelfaktor der Anordnung nur schwach von der Frequenz abhängig. Diese Laseranordnung hat daher eine verbesserte Frequenzstabilität im Vergleich zum Stand der Technik.

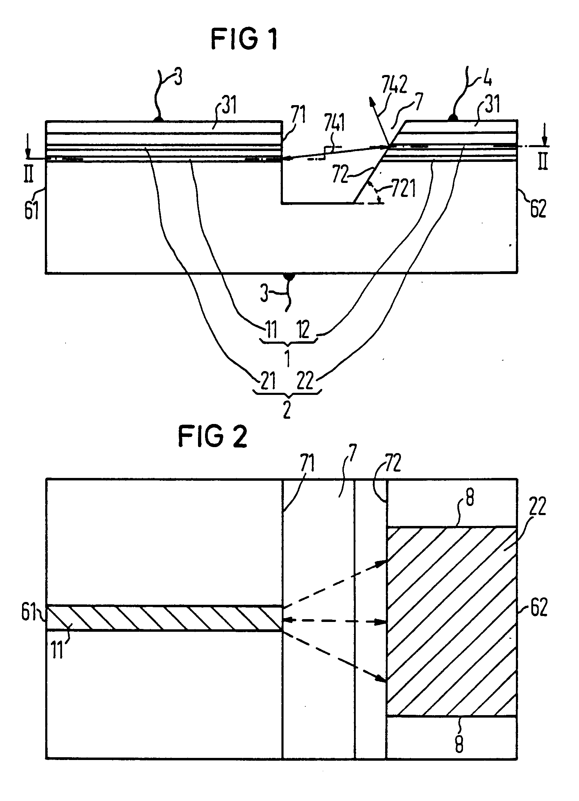

Die Laseranordnung nach Fig. 1 hat den Vorteil, daß der Laserresonator und der passive Resonator monolithisch integriert in einem Halbleiterschichtaufbau enthalten sind. Dadurch vereinfacht sich die Justierung beträchtlich. Die für eine optimale Frequenzstabilität der Laseranordnung erforderliche schwache Kopplung kann in dieser Anordnung durch den Neigungswinkel der schrägen Flanke und-die Breite des Grabens reproduzierbar eingestellt werden. Da sich der passive Resonator von der senkrechten Flanke des geätzten Grabens bis zur Stirnfläche des Halbleiterschichtaufbaus, die sich an der der senkrechten Flanke abgewandten Seite des geätzen Grabens befindet, erstreckt, machen sich durch den Herstellungsprozeß bedingte Toleranzen in der Grabenbreite im Betrieb der Laseranordnung nicht bemerkbar.

Die Laseranordnung hat außerdem den Vorteil, daß eine Dämpfung der Laserstrahlung durch optische Kopplung in transversaler Richtung zwischen der laseraktiven Schicht und der transparenten Wellenleiterschicht vermieden wird.

Die Laseranordnung nach Fig. 2 weist als passiven Resonator einen zweidimensionalen dielektrischen Scheibenresonator auf.

Ein solcher Scheibenresonator hat bei gleicher Länge eine wesentlich höhere Güte als ein streifenförmiger Resonator.

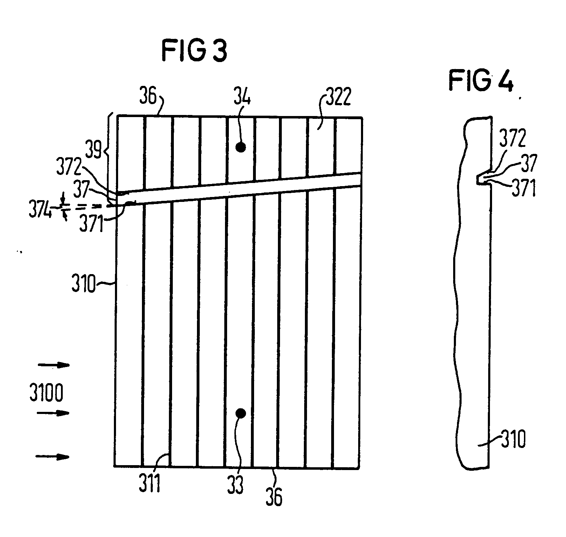

Mit der Laseranordnung nach Fig. 3 und 4 ist es möglich, einen sowohl longitudinal als auch lateral einmodigen Schwingungszustand zu erhalten.

Ausführungsbeispiele der Erfindung werden im folgenden anhand der FIG näher erläutert.

FIG 1 zeigt einen Schnitt durch eine Laseranordnung.

FIG 2 zeigt die Draufsicht der Laseranordnung.

FIG 3 zeigt eine Anordnung, die mehrere lateral verkoppelte Laser enthält.

FIG 4 zeigt eine schematische Seitenansicht der Anordnung aus FIG 3.

In FIG 1 ist ein Halbleiterschichtaufbau dargestellt, der eine laseraktive Schicht 1 und eine Wellenleiterschicht 2 enthält. Der Halbleiterschichtaufbau besteht z. B. aus InP/InGaAsP. Die laseraktive Schicht 1 besteht z. B. aus InGaAsP mit einem Bandabstand entsprechend einer Wellenlänge von 1,3 $\mu$m. Die Wellenleiterschicht 2 ist für die Laserstrahlung transparent. Sie besteht z. B. aus InGaAsP mit einem Bandabstand entsprechend einer Wellenlänge von 1,15 $\mu$m. Der Abstand zwischen der laseraktiven Schicht 1 und der Wellenleiterschicht 2 im Halbleiterschichtaufbau ist so gewählt, daß zwischen der laseraktiven Schicht 1 und der Wellenleiterschicht 2 durch das Halbleitermaterial keine optische Kopplung auftritt. Die laseraktive Schicht 1 und die Wellenleiterschicht 2 weisen Dicken von jeweils etwa 0,1 bis 0,3 $\mu$m auf. Der Abstand zwischen der laseraktiven Schicht 1 und der Wellenleiterschicht 2 beträgt etwa einige Zehntel $\mu$m. Der Halbleiterschichtaufbau wird in seiner Länge durch Stirnflächen begrenzt. Die Stirnflächen sind natürliche Bruchflächen und wirken als Spiegel. Die Stirnflächen enthalten eine linke Stirnfläche 61 und eine rechte Stirnfläche 62. Der Halbleiterschichtaufbau weist einen Graben 7 auf. Der Graben 7 verläuft senkrecht zu der Linie, die die Stirnflächen verbindet. Der Graben 7 ist so tief, daß er die laseraktive Schicht 1 und die Wellenleiterschicht 2 in jeweils zwei Teile teilt. Der Graben 7 weist eine senkrechte Flanke 71 auf. Ferner weist der Graben 7 eine schräge Flanke 72 auf. Die schräge Flanke 72 hat einen Neigungswinkel 721.

Die laseraktive Schicht 1 wird durch den Graben 7 in einen Laserresonator 11 und in einen rechten Teil der laseraktiven Schicht 12 aufgeteilt. Die Wellenleiterschicht 2 wird durch den Graben 7 in einen linken Teil der Wellenleiterschicht 21 und in einen rechten Teil der Wellenleiterschicht 22 aufgeteilt. Die senkrechte Flanke 71 wirkt als Spiegel für den Laserresonator 11. Der Laserresonator 11 erstreckt sich zwischen der der schrägen Flanke 72 abgewandten linken Stirnfläche 61 und der senkrechten Flanke 71.

Der rechte Teil der Wellenleiterschicht 22 erstreckt sich zwischen der schrägen Flanke 72 und der rechten Stirnfläche 62, die der schrägen Flanke 72 zugewandt ist. Die senkrechte Flanke 71 bildet ebenfalls eine Spiegelfläche für einen Resonator, der von dem rechten Teil der Wellenleiterschicht 22 und dem Luftspalt im Graben 7 zwischen der senkrechten Flanke 71 und der rechten Stirnfläche 62 gebildet wird.

Licht, das aus dem Laserresonator 11 in den Graben 7 austritt, wird an der schrägen Flanke 72 teilweise reflektiert (in FIG 1 als Auskoppelpfeil 742 dargestellt), teilweise wird es in den rechten Teil der Wellenleiterschicht 22 eingekoppelt (in FIG 1 als Kopplungspfeil 741 dargestellt). Der Neigungswinkel der schrägen Flanke 72 ist so gewählt, daß das zurückreflektierte Licht nicht in den Laserresonator 11 gelangen kann. Der Neigungswinkel 721 ist ferner so gewählt, daß die Kopplungsstärke einen stabilen Arbeitspunkt der Laseranordnung gewährleistet. Besonders vorteilhaft ist es, den Neigungswinkel 721 in einer Größe von 45° zu wählen.

Durch die schräge Flanke 72 ist es auch möglich, Laserlicht senkrecht zur Längsausdehnung des Laserresonators 11 aus der Laseranordnung auszukoppeln. Das aus dem Laserresonator 11 austretende Licht wird an der schrägen Flanke 72 teilweise nach oben reflektiert und tritt senkrecht zur Schichtenfolge aus dem Halbleiterschichtaufbau aus.

Zum Betrieb der Laseranordnung ist der Halbleiterschichtaufbau über eine Kontaktschicht 31 mit Kontakten 3 versehen. Die Kontakte 3 sind an gegenüberliegenden Flächen des Halbleiterschichtaufbaus angebracht, so daß die laseraktive Schicht 1 und die Wellenleiterschicht 2 zwischen den Kontakten 3 liegen. Der Kontakt 3, der auf derjenigen Oberfläche des Halbleiterschichtaufbaus angebracht ist, in der sich auch der Graben 7 befindet, befindet sich oberhalb des Laserresonators 11. Um etwaige Dämpfungsverluste im rechten Teil der Wellenleiterschicht 22 auszugleichen, ist ein zusätzlicher Kontakt 4 vorgesehen. Der zusätzliche Kontakt 4 befindet sich oberhalb des rechten Teils der laseraktiven Schicht 12 auf derjenigen Oberfläche des Halbleiterschichtaufbaus, in der der Graben 7 ist.

In FIG 2 ist der in FIG 1 mit II bezeichnete Schnitt der Laseranordnung dargestellt. Durch laterale Wellenführung ist der Laserresonator 11 auf einen Streifen begrenzt. Die laterale Wellenführung kann durch eine gebräuchliche Methode wie z. B. Gewinnführung oder Indexführung erreicht werden. Der rechte Teil der Wellenleiterschicht 22 wird durch seitliche Spiegelflächen 8 begrenzt. Die Ausdehnung zwischen den seitlichen Spiegelflächen 8 ist um ein Vielfaches größer als die Breite des streifenförmigen Laserresonators 11. Die seitlichen Spiegelflächen 8 werden z. B. durch Ätzen gewonnen.

Das in den rechten Teil der Wellenleiterschicht 22 eingekoppelte Licht breitet sich sowohl in longitudinaler als auch in lateraler Richtung aus und wird an der rechten Stirnfläche 62, die eine natürliche Bruchfläche ist, und an den beiden seitlichen Spiegelflächen 8 reflektiert. Daher wirkt der rechte Teil der Wellenleiterschicht 22 und der Luftspalt des Grabens 7 bis zur senkrechten Flanke 71 zwischen den seitlichen Spiegelflächen 8 als zweidimensionaler dielektrischer Scheibenresonator (siehe FIG 2). Die Güte eines Scheibenresonators ist bei gleicher Länge-wesentlich höher als die eines streifenförmigen Resonators. Daher weist diese Laseranordnung ein geringeres Frequenzrauschen und damit eine kleinere Linienbreite auf als Laseranordnungen mit streifenförmigen Resonatoren.

Da als Resonator der Bereich zwischen der senkrechten Flanke 71 und der rechten Stirnfläche 62 wirkt, machen sich durch den Herstellungsprozeß bedingte Toleranzen in der Weite des Grabens 7 nicht bemerkbar.

In FIG 3 ist ein weiteres Ausführungsbeispiel der Erfindung dargestellt. In diesem Ausführungsbeispiel sind mehrere, z. B. acht, Streifenlaser 311 in einem Halbleiterkörper 310 integriert. Die Streifenlaser 311 sind analog aufgebaut wie der Laserresonator 11 aus dem ersten Ausführungsbeispiel in FIG 1 und FIG 2. Die Streifenlaser 311 sind untereinander lateral verkoppelt. In longitudinaler Richtung sind die Streifenlaser 311 mit Resonatoren 39 verkoppelt. Die Resonatoren 39 setzen sich zusammen aus einem Wellenleiteranteil 322 und dem Luftspalt eines Grabens 37. Als Resonatorspiegel wirken eine senkrechte Flanke 371 des Grabens 37 und eine Stirnfläche 36 des Halbleiterkörpers 310, die sich an der den Streifenlasern 311 abgewandten Seite des Grabens 37 befindet. Der Graben 37 ist analog dem Graben 7 des ersten Ausführungsbeispiels geätzt. Er weist neben der senkrechten Flanke 371 eine schräge Flanke 372 auf. Der Graben 37 verläuft quer zu den Streifenlasern 311, wobei der Graben 37 mit der Senkrechten zur Längsrichtung der Streifenlaser 311 einen Winkel 374 von 0° bis 20° bildet. Durch diesen schrägen Verlauf des Grabens 37 haben alle Streifenlaser 311 ein etwas unterschiedliches Längenverhältnis zu dem jeweiligen Resonator 39. Dadurch wird eine zusätzliche Frequenzselektion in longitudinaler Richtung realisiert. Dadurch ist es möglich die lateralen Supermoden der Anordnung zu selektieren und damit einen sowohl longitudinal als auch lateral einmodigen Schwingungszustand zu erhalten.

Zum Betrieb der Laseranordnung sind weitere Kontakte 33 vorgesehen. Sie sind analog den Kontakten 3 in FIG 1 so am Halbleiterkörper 310 angebracht, daß die Streifenlaser darunter liegen. Ein weiterer zusätzlicher Kontakt 34 ist vorgesehen, um etwaige Dämpfungsverluste auszugleichen (s. FIG 3).

In FIG 4 ist eine schematische Seitenansicht der Laseranordnung aus FIG 3 dargestellt. Die Seitenansicht bezieht sich auf die Richtung, die in FIG 3 durch Pfeile 3100 angedeutet ist. In die Oberfläche des Halbleiterkörpers 310 ist der Graben 37 eingeätzt. Die Seitenansicht soll das Ätzprofil des Grabens 37 mit der senkrechten Flanke 371 und der schrägen Flanke 372 veranschaulichen.

## Patentansprüche

1. Laseranordnung mit mindestens einem Laserresonator und einem damit in longitudinaler Richtung verkoppelten passiven Resonator, die in einem Halbleiterschichtaufbau monolithisch integriert sind,
   – mit einer aktiven Schicht (1) für den Laserresonator,
   – mit einer Wellenleiterschicht (2) für den passiven Resonator,
   – mit einem Graben (7), der eine zu der aktiven Schicht (1) senkrechte Flanke (71) und eine zu der Wellenleiterschicht (2) um einen Neigungswinkel (721) geneigte schräge Flanke (72) hat,
   – wobei die senkrechte Flanke (71) eine Spiegelfläche zwischen dem Laserresonator und dem passiven Resonator bildet und die schräge Flanke (72) den passiven Resonator schneidet, mit der Maßgabe,
   – daß die aktive Schicht (1) und die Wellenleiterschicht (2) übereinander angeordnet aufgewachsen sind,
   – daß der Abstand zwischen der aktiven Schicht (1) und der Wellenleiterschicht (2) so ist, daß keine opitsche Kopplung durch Halbleitermaterial zwischen der aktiven Schicht (1) und der Wellenleiterschicht (2) erfolgt,
   – daß der Neigungswinkel (721) der schrägen Flanke (72) so bemessen ist, daß die an der senkrechten Flanke (71) aus der aktiven Schicht (1) austretende Strahlung nicht in die aktive Schicht (1) zurückreflektiert wird, und
   – daß die Breite des Grabens (7) und der Neigungswinkel (721) zueinander so bemessen sind, daß Strahlung aus der aktiven Schicht in den in dem passiven Resonator (7, 22) angeordneten Teil der Wellenleiterschicht (22) gekoppelt (741) wird.

2. Laseranordnung nach Anspruch 1,
   **dadurch gekennzeichnet,**
   daß der passive Resonator (7, 22) mit einem zusätzlichen Kontakt (4) versehen ist.

3. Laseranordnung nach Anspruch 1 oder 2,
   **dadurch gekennzeichnet,**
   – daß der passive Resonator (7, 22) als zweidimensionaler dielektrischer Scheibenresonator ausgebildet ist,
   – daß der in dem passiven Resonator (7, 22) angeordnete Teil der Wellenleiterschicht (22) lateral durch je eine seitliche Spiegelfläche (8) begrenzt ist,
   – daß diese seitlichen Spiegelflächen (8) voneinander einen Abstand haben, der die Breite des Laserresonators (11) um ein Vielfaches übertrifft, und
   – daß der Graben (7) senkrecht zur Längsrichtung des Laserresonators (11) verläuft.

4. Laseranordnung nach Anspruch 1 oder 2,
   **dadurch gekennzeichnet,**
   – daß mehrere lateral verkoppelte Streifenlaser (311) in der aktiven Schicht (1) ausgebildet sind,
   – daß diesen Streifenlasern (311) jeweils ein passiver Resonator (39) zugeordnet ist,
   – daß die Streifenlaser (311) und die passiven Resonatoren (39) auf der der senkrechten Flanke (371) des Grabens (37) jeweils gegenüberliegenden Seite jeweils durch eine senkrecht zur Längsrichtung der Streifenlaser (311) angeordnete Stirnfläche (36) begrenzt sind und
   – daß der Graben (37) in einem Winkel Kleiner als 90° und mindestens 70° zu der Längsrichtung dieser Streifenlaser (311) verläuft, so daß das Verhältnis der Länge eines Streifenlasers (311) zu der Länge des diesem zugeordneten passiven Resonators (39) von einem Streifenlaser (311) zum nächsten variiert.

## Claims

1. Laser arrangement having at least one laser resonator and a passive resonator, coupled thereto in the longitudinal direction, which are monolithically integrated in a semiconductor layer construction,
– having an active layer (1) for the laser resonator,
– having a waveguide layer (2) for the passive resonator,
– having a trench (7) which has a flank (71) which is vertical with respect to the active layer (1) and an oblique flank (72) which is inclined through an inclination angle (721) with respect to the waveguide layer (2),
– the vertical flank (71) forming a mirror surface between the laser resonator and the passive resonator, and the oblique flank (72) cutting the passive resonator, characterised
– in that the active layer (1) and the waveguide layer (2) are grown arranged one above the other,
– in that the distance between the active layer (1) and the waveguide layer (2) is such that there is no optical coupling through the semiconductor material between the active layer (1) and the waveguide layer (2),
– in that the inclination angle (721) of the oblique flank (72) is dimensioned such that the radiation emerging from the active layer (1) on the vertical flank (71) is not reflected back into the active layer (1), and
– in that the width of the trench (7) and the inclination angle (721) are dimensioned with respect to one another such that radiation from the active layer is coupled (741) into the part of the waveguide layer (22) arranged in the passive resonator (7, 22).

2. Laser arrangement according to Claim 1,
**characterised**
– in that the passive resonator (7, 22) is provided with an additional contact (4).

3. Laser arrangement according to Claim 1 or 2,
**characterised**
– in that the passive resonator (7, 22) is constructed as a two-dimensional dielectric disc resonator,
– in that the part of the waveguide layer (22) arranged in the passive resonator (7, 22) is laterally bounded by in each case one lateral mirror surface (8),
– in that these lateral mirror surfaces (8) are at a distance from one another which exceeds the width of the laser resonator (11) by a multiple, and
– in that the trench (7) runs vertically with respect to the longitudinal direction of the laser resonator (11).

4. Laser arrangement according to Claim 1 or 2,
**characterised**
– in that a plurality of laterally coupled stripe lasers (311) are constructed in the active layer (1),
– in that these stripe lasers (311) each have a passive resonator (39) allocated to them,
– in that the stripe lasers (311) and the passive resonators (39) on the side opposite to the vertical flank (371) of the trench (37) are each bounded by an endface (36) arranged vertically with respect to the longitudinal direction of the stripe laser (311) and
– in that the trench (37) runs at an angle of less than 90° and at least 70° with respect to the longitudinal direction of this stripe laser (311) such that the ratio of the length of a stripe laser (311) to the length of the passive resonator (39) allocated thereto varies from one stripe laser (311) to the next.

## Revendications

1. Dispositif laser comportant au moins un résonateur laser et un résonateur passif couplé au précédent dans la direction longitudinale, ces résonateurs étant intégrés de façon monolithique dans une structure de couches semiconductrices, et comportant
– une couche active (1) pour le résonateur laser,
– une couche formant guide d'ondes (2) pour le résonateur passif,
– un sillon (7), qui possède un flanc (71) perpendiculaire à la couche active (1), et un flanc oblique (72) incliné d'un angle d'inclinaison (721) par rapport à la couche formant guide d'ondes (2),
– le flanc perpendiculaire (71) formant une surface réfléchissante entre le résonateur laser et le résonateur passif, tandis que le flanc oblique (72) recoupe le résonateur passif, avec les conditions selon lesquelles
– la couche active (1) et la couche formant guide d'ondes (2) sont formées par croissance en superposition,
– la distance entre la couche active (1) et la couche formant guide d'ondes (2) est telle qu'aucun couplage optique n'est réalisé par l'intermédiaire du matériau semiconducteur entre la couche active (1) et la couche formant guide d'ondes (2),
– que l'angle d'inclinaison (721) du flanc oblique (72) est dimensionné de manière que le rayonnement sortant de la couche active (1) au niveau du flanc perpendiculaire (71) n'est pas rétroréfléchi dans la couche active (1), et

– que la largeur du sillon (7) et l'angle d'inclinaison (721) sont dimensionnés l'un par rapport à l'autre de manière que le rayonnement sortant de la couche active soit injecté par couplage (741) dans la partie, située dans le résonateur passif (7,22), de la couche formant guide d'ondes (22).

2. Dispositif laser suivant la revendication 1, caractérisé par le fait que le résonateur passif (7,22) comporte un contact supplémentaire (4).

3. Dispositif laser suivant la revendication 1 ou 2,

**caractérisé par le fait**

– que le résonateur passif (7,22) est réalisé sous la forme d'un résonateur en forme de plaque diélectrique bidimensionnelle,

– que la partie, disposée dans le résonateur passif (7,22), de la couche formant guide d'ondes (22) est limitée latéralement respectivement par une surface réfléchissante latérale (8),

– que ces surfaces réfléchissantes latérales (8) sont séparées l'une de l'autre par une distance qui est supérieure, d'un multiple, à la largeur du résonateur laser (11), et

– que le sillon (7) est perpendiculaire à la direction longitudinale du résonateur laser (11).

4. Dispositif laser suivant la revendication 1 ou 2,

**caractérisé par le fait**

– que plusieurs lasers en forme de bandes (311), couplés latéralement, sont formés dans la couche active (1),

– que des résonateurs passifs (39) sont associés respectivement à ces lasers en forme de bandes (311),

– que les lasers en forme de bandes (311) et les résonateurs passifs (39) sont limités, sur la face située respectivement à l'opposé du flanc perpendiculaire (371) du sillon (37), respectivement par une surface frontale (36) perpendiculaire à la direction longitudinale des lasers en forme de bandes (311), et

– que le sillon (37) fait un angle inférieur à 90° et au moins égal à 70° par rapport à la direction longitudinale de ces lasers en forme de bandes (311) en sorte que le rapport de la longueur d'un laser en forme de bande (311) à la longueur du résonateur passif (39) associé à ce laser, varie d'un laser en forme de bande (311) au suivant.

## FIG 1

## FIG 2

# FIG 3

# FIG 4